(19) Europäisches Patentamt
European Patent Office
Office européen des brevets

(11) Publication number: **0 014 785**
**B1**

(12) **EUROPEAN PATENT SPECIFICATION**

(45) Date of publication of patent specification: **12.06.85**

(51) Int. Cl.[4]: **C 08 G 75/04,** G 03 C 1/68

(21) Application number: **79300208.0**

(22) Date of filing: **12.02.79**

(54) **Coating method and curable compositions.**

(43) Date of publication of application:
**03.09.80 Bulletin 80/18**

(45) *Publication of the grant of the patent:*
**12.06.85 Bulletin 85/24**

(84) Designated Contracting States:
**DE FR GB IT NL SE**

(56) References cited:
**FR-A-2 285 423**
**GB-A-1 516 065**
**US-A-3 729 404**
**US-A-4 058 400**
**US-A-4 069 056**

(73) Proprietor: **GENERAL ELECTRIC COMPANY**
**1 River Road**
**Schenectady New York 12305 (US)**

(72) Inventor: **Crivello, James Vincent**
**R.D. No.1 Carlton Road**
**Clifton Park New York (US)**

(74) Representative: **Turner, Paul Malcolm et al**
**PAUL M. TURNER AND COMPANY European Patent Attorneys 47 Marylebone Lane**
**London W1M 6DL (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 014 785 B1

Courier Press, Leamington Spa, England.

## Description

The present invention relates to ultraviolet radiation curable compositions having a polyolefin component and a polythiol component and an effective amount of a photoinitiator. The present invention also relates to a coating method involving the application of the aforementioned curable compositions onto a substrate followed by exposing the treated substrate with ultraviolet radiation.

Prior to the present invention, photocurable compositions such as Kehr et al U.S. Patents 3,697,395, 3,697,402 and 3,700,574 showed that curable liquid polyenepolythiol mixtures could be converted to solid elastomeric products. As further discussed by Kehr et al in Division of Organic Coatings and Plastics Chemical, Vol. 33, No. 1, of April 8—13, 1973, on page 295, the photocure of such polythiol-polyene system is identified as a free radical cure requiring an inhibitor to improve the shelf life of the composition. A photocuring rate accelerator is employed, such as benzophenone, to effect addition between the polyene component and the polythiol component resulting in the production of an elastomeric coating.

Although effective results can be achieved with the above-described free-radical initiated curing system of Kehr et al, a significant amount of inhibitor must be used to offset premature gellation. Experience has shown, however, that the use of inhibitors to improve the shell life of the curable polythiol-polyene mixture also lengthens the cure time of the mixture. As shown by the above Kehr et al. patents, cure times of several minutes to several days are not unusual.

US 3729404 describes the accelerated curing of a polyene and polythiol using certain phosphine or phosphite synergistic agents. The object of the invention is to provide curable compositions which can be cured at ambient temperatures below 121°C. This is achieved using, for example, a sunlamp having a heat intensity of $0.4 \times 10^{-6}$ W/m$^2$ and a benzophenone photosensitizer resulting in the production of an elastomeric coating.

US 4058400 describes the cationic polymerization of organic materials, such as vinyl monomers, prepolymers, cyclic ethers, cyclic esters, cyclic sulfides and organosilicon cyclics, using radiation sensitive aromatic onium salts of sulfur, selenium or tellurium and exposing the composition to ultraviolet radiation.

US 4068056 describes the cationic polymerization of organic materials, such as vinyl monomers, prepolymers, cyclic ethers, cyclic esters, cyclic amines, cyclic sulfides and organosilicon cyclics, using radiation sensitive onium salts of nitrogen, phosphorus, arsenic, antimony or bismuth and exposing the composition to ultraviolet light.

The present invention is based on the discovery that liquid polythiol-polyene mixtures can be converted to elastomeric solids by a condensation polymerization method. A photocurable mixture is provided which does not require the use of an inhibitor, and which can be cured to a coating having a thickness of up to 0.5 mm or more. A faster cure can be achieved by substituting an onium salt photoinitiator for the free radical photocuring rate accelerator of the prior art. Onium salts, such as triphenylsulfoniumfluoroborate, are capable of releasing a Lewis Acid catalyst upon exposure to ultraviolet light. Included among the preferred onium salts which can be used in the photocurable compositions of the invention, are compounds such as triarylsulfonium hexafluoroarsenate salts. Although less effective than the aforedescribed onium salts because of the requirement of the need of a stabilizer, and undesirable side reactions, such as bubbling and discoloration due to nitrogen release, diazonium compounds such as shown by Schlesinger U.S. Patent 3,703,296, also provide for condensation polymerization based on the release of a Lewis Acid.

There are provided by the present invention, curable compositions comprising, a polyolefin component, a polythiol component, and an effective amount of an ultraviolet radiation photoinitiator of the formula,

(1) $$(Y^+)_J\,(MX_K)^{-(K-L)},$$

where M is a metal or metalloid, and $Y^+$ is a cation selected from the class consisting of

$$[(R)_a\,(R^1)_b\,Q]^+,\ [(R)_c\,(R^2)_d\,(R^3)_e\,D]^+,\ [(R)_f\,(R^4)_g\,(R^5)_h\,Z]^+, \text{ and}$$

R is a monovalent aromatic organic radical, $R^1$ is a divalent aromatic organic radical, $R^2$ is a monovalent organic aliphatic radical selected from alkyl, cycloalkyl and substituted alkyl, $R^3$ is a polyvalent organic radical forming a heterocyclic or fused ring structure selected from aliphatic radicals and aromatic radicals, $R^4$ is a monovalent organic aliphatic radical selected from alkyl, alkoxy, cycloalkyl, haloalkyl and alkoxyalkyl, $R^5$ is a polyvalent organic radical forming an aromatic heterocyclic or fused ring structure where Q and X are halogen radicals such as I, Br, Cl, or F, D is an element selected from sulfur, selenium and tellurium, Z is an element selected from N, P, As, Sb and Bi, a is 0 or 2, b is 0 or 1, the sum of a + b is equal to 2 or to the valence of Q, c is 0 or 3, d is 0, 1 or 2, e is 0 or 1, where the sum of c + d + e is a value equal to 3 or the valence of D, f is 0, 1, 2, 3 or 4, g is a whole number equal to 0, 1 or 2, h is 0, 1 or 2, and the sum of f + g + h is a value equal to 4 or the valence of Z,

$J = K-L$

$L$ = valence of M and is an integer equal to 2 to 7 inclusive, and

$K > L$ and is an integer having a value up to 8.

Radicals included by R can be the same or different, aromatic carbocyclic or heterocyclic radical having from 6 to 20 carbon atoms, which can be substituted with from 1 to 4 monovalent radicals selected from $C_{(1-8)}$ alkoxy, $C_{(1-8)}$ alkyl, nitro, chloro, R is more particularly phenyl, chlorophenyl, nitrophenyl, methoxyphenyl, pyridyl. Radicals included by $R^1$ are divalent radicals such as

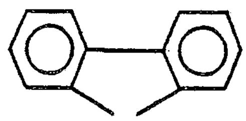 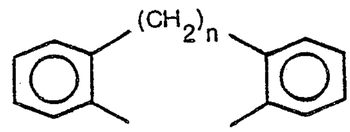 ,

$R^2$ radicals include $C_{(1-8)}$ alkyl such as methyl, ethyl, etc., substituted alkyl such as $-C_2H_4OCH_3$, $-CH_2COOC_2H_5$, $-CH_2COCH_3$. $R^3$ radicals include such structures as:

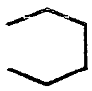 , 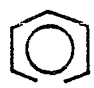 , 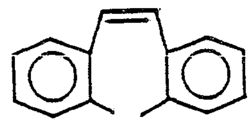 , 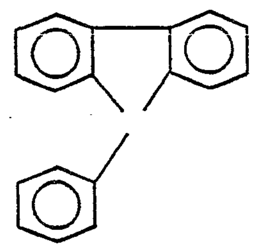 ,

$R^4$ radicals include $C_{(1-8)}$ alkyl, $C_{(3-8)}$ cycloalkyl, substituted alkyl such as haloalkyl, for example, chloroethyl, alkoxy such as $OCH_2C_6H_5$ and $OCH_3$; alkoxyalkyl such as $C_nH_{2n}OCH_3$. Radicals included by $R^5$ are, for example,

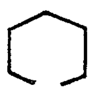 , 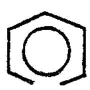 , 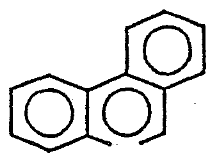 , 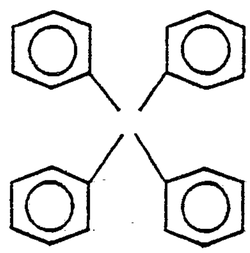 , 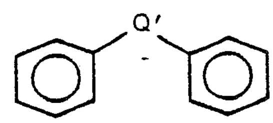 ,

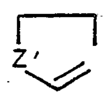 , 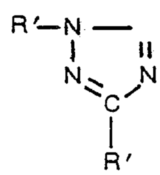 ,

where Q′ is selected from O, $CH_2$, N, and S; Z′ is selected from —O—, —S— and

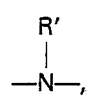

and R′ is a monovalent radical selected from hydrogen and hydrocarbon.

Metal or metalloids included by M of formula 1 are transition metals such as Sb, Fe, Sn, Bi, Al, Ga, In, Ti, Zr, Sc, V, Cr, Mn, Cs, rare earth elements such as the lanthanides, for example, Cd, Pr, Nd, and metalloids such as B, P, As. Complex anions included by $(MX_K)^{-K-L}$ are, for example, $BF_4^-$, $PF_6^-$, $AsF_6^-$, $SbF_6^-$, $FeCl_4^=$, $SnCl_6^-$, $SbCl_6^-$, $BiCl_5^=$.

Halonium salts included by Formula 1 are, for example,

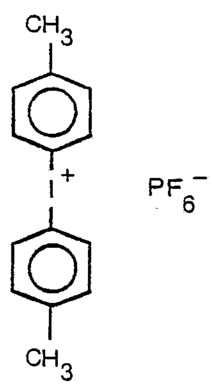

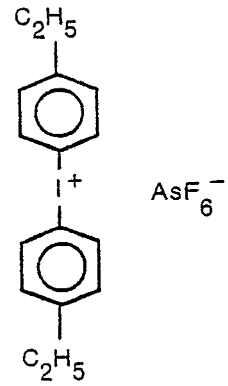

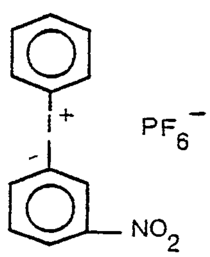

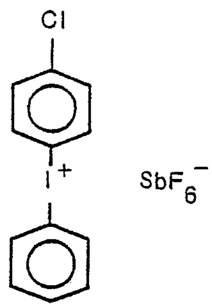

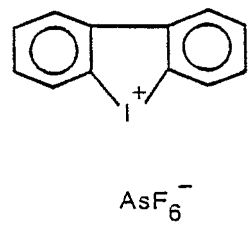

Onium salts included by Formula 1 are, for example,

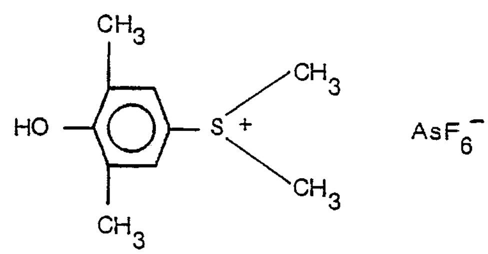

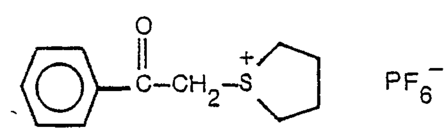

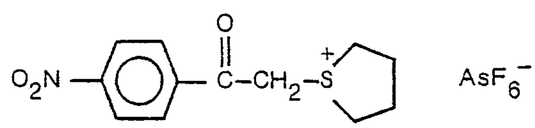

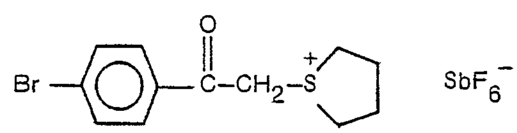

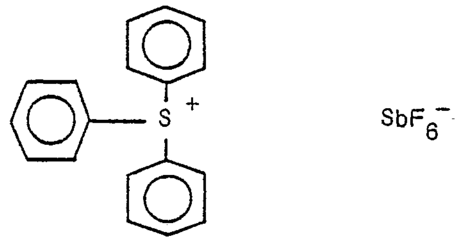

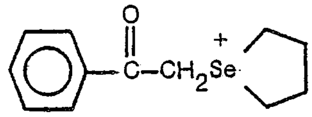 $PF_6^-$

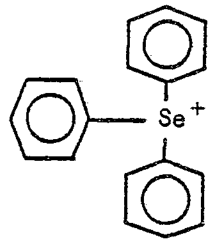 $SbF_6^-$

Further onium salts included by Formula 1 are, for example,

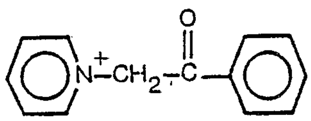 $SbF_6^-$ , 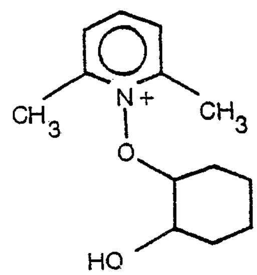 $AsF_6^-$ ,

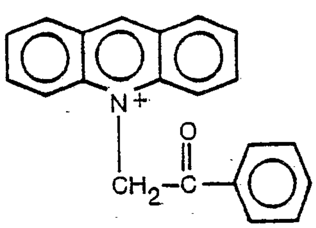 $PF_6^-$ , 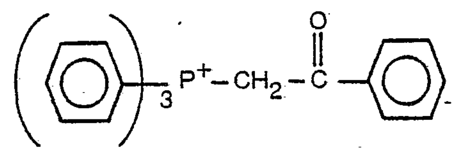 $AsF_6^-$ ,

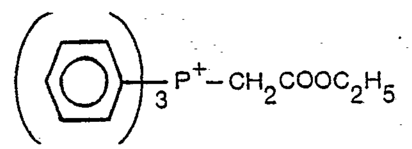 $PF_6^-$ .

Some of the photoinitiators used in the curable compositions as the present invention can be made by effecting contact under aqueous conditions between an arylhalonium bisulfate and the corresponding hexafluoro acid or salt, such as $Y^1$ M $F_6$ where $Y^1$ can be hydrogen, an alkali metal ion, alkaline earth metal ion or transition metal ion.

In addition to the above-described metathesis for making the corresponding halonium salts, the halonium salts of the present invention also can be prepared by using silver compounds, such as silver oxide, or silver tetrafluoroborate, which were reacted with the appropriate diarylhalonium salt, as shown by M. C. Caserio et al., J. Am. Chem. Soc. 81, 336 (1959) or M. C. Beringer et al., J. Am. Chem. Soc. 81, 342 (1959). Methods for making compounds, such as sulfonium, selenium and tellurium compounds, where Y of Formula 1 contains an X radical can be made by procedures shown in J. W. Knapczyk and W. E. McEwen, J. Am. Chem. Soc., *91* 145, (1969); A. L. Maycock and G. A. Berchtold, J. Org. Chem., *35* No. 8,2532 (1970); H. M. Pitt, U.S. Patent 2,807,648, E. Goethals and P. De Radzetzky, Bul. Soc. Chim. Belg., *73* 546 (1964); H. M. Leicester and F. W. Bergstrom, J. Am. Chem. Soc., *51* 3587 (1929).

Among the procedures which can be used to make onium salts, arsonium, antimonium and bimuthonium salt, where Y in Formula 1 is a Z radical can be found in Goerdeler, Methoden der Organishen Chimie 11/2, 591—640 (1958) and K. Sasse, ibid, 12/1 79—112 (1963).

Some of the polyolefins which can be used in the photocurable compositions of the present invention are shown by Kehr et al U.S. patent 3,697,396, in Col. 3, Lines 5—55 and Col. 4, Lines 1—15. Generally any polyolefin can be used in the practice of the invention having the following formula,

(2) $$[A]\!-\!\!-[D]_x$$

where x is an integer having a value of at least 2, A is a polyvalent organic radical or an organosilicon radical free of reactive olefinic unsaturation consisting essentially of chemically combined atoms, such as

carbon, oxygen, nitrogen, phosphorous, silicon, and mixtures thereof together with monovalent atoms such as chlorine, bromine, fluorine, hydrogen, and D is an olefinically unsaturated monovalent organic radical, including, but not limited to, radicals shown in Column 3, Lines 5—41 of Kehr et al U.S. Patent 3,697,396. Typical of the polyolefin components which can be used in the practice of the invention are polyurethanes formed by reacting poly(alkylene-ether) polyols with aliphatically unsaturated monoisocyanates, the aforementioned polyols reacted with unsaturated monoalcohols and organic polyisocyanates. The preparation of the aforesaid polyurethanes are in accordance with standard procedures using organometallic catalysts.

The polythiol component which can be used in the practice of the invention can have a molecular weight in the range of from 50 to 20,000 and is included by the formula

(3) $$G{-}(SH)_y$$

where G is a polyvalent organic radical, free of aliphatic unsaturation, and y is an integer having a value of at least 2. G is more particularly an organic radical which can contain hetero atoms such as N, P or O in addition to chemically combined carbon atoms, carbon and hydrogen atoms, carbon and oxygen atoms and silicon and oxygen atoms. Included among the polythiols are esters of thiol containing acids and polythiols such as ethanedithiol, hexamethylenedithiol, tolylene-2,4-dithiol and certain polymeric polythiols, such as thiol-terminated ethylcyclohexyldimercaptan polymer. Certain polythiol compounds are preferred because of relatively low odor level such as esters of thioglycolic acid, alpha-mercaptopropionic acid and beta-mercaptopropionic acid with polyhydroxy compounds such as glycols, triols, tetrols, pentols, and hexols. A few of the examples of the polythiols which can be employed in making the curable compositions of the present invention are: ethylene glycol bis(thioglycolate), ethyleneglycol bis(β-mercaptopropionate), trimethylolpropane bis(thioglycolate). The preferred polythiol compounds are characterized by being substantially free of mercaptan like odor, resulting in the production of substantially odor free coating products.

The curable compositions of the present invention may be employed as compositions free of an organic solvent or used as a coating material at 100% solids containing the active ingredients of the polyolefin component and the polythiol and the photoinitiator as previously described. The curable compositions of the present invention can be applied onto a variety of substrates such as plastics, glass, wood, steel, aluminium, as a dispersion, or an emulsion in an aqueous media. In addition, the curable compositions of the present invention can be pumped, poured, siphoned, brushed, sprayed, doctored, or otherwise applied on the aforementioned substrates in a desirable manner. The curable compositions also can be blended prior to cure with other monomeric and polymeric materials such as thermoplastic resins, elastomers of thermosetting resins to modify the curing characteristics of the resulting cured product.

It has been found that if prior to cure, substantial stoichiometric equivalents of reactive functionality is maintained in the curable mixture of the polyolefinic components containing carbon to carbon double bond unsaturation, with SH containing radicals of the polythiol components, the resulting curable coating composition will have optimum coating characteristics. The mole ratio of ene to thiol groups in the UV curable composition can be from 0.2/1 to 5/1 and preferably from 0.75/1 to 1.5/1. Included among the desirable characteristics of the coating compositions of the present invention are, for example, flexibility, solvent resistance, weatherability, insulating characteristics.

The order of addition of the various ingredients into the curable mixture is not critical. For example, the photoinitiator can be added directly to or prepared *in situ* in the mixture of the polyolefin and the polythiol and can be present in a proportion of from 0.25 to 10% by weight and preferably from 0.5 to 3% based on the weight of UV curable composition. There also can be utilized such additives as antioxidants, accelerators, dyes, inhibitors, activators, fillers, pigments, antistatic agents, flame retardant agents, thickeners, thixotropic agents, surface active agents, viscosity modifiers, extending oils, plasticizers, tackifiers and other ingredients normally used to modify the characteristics of a curable coating formulation. Fillers such as natural and synthetic resins, carbon black, alumina, wood flour, mica, silica, aluminium and a proportion of such additives such as in an amount of 500 parts or more per 100 parts of curable mixture can be used and preferably from .5% to 300 parts per 100 parts of the curable mixture. Conventional sources of the ultraviolet light such as medium pressure mercury arc lamps, e.g., Hanovia lamps and GE H3T7 lamps, type RS sunlamps, Xenon flash lamps, carbon arc lamps, can be used effectively.

Among the uses of the curable compositions of the present invention are, for example, adhesives, calks, elastomeric sealants, coatings, incapsulating or potting compounds, liquid castable elastomers, thermoset resins, impregnants for fabric cloth, fibrous webs and other porous substrates.

In addition, the curable compositions can be used as matrix materials for composites of glass fibers, carbon fibers, steel fibers, thermosetting resins or elastomers as molding compounds to make gaskets, diaphrams.

In order that those skilled in the art will be better able to practice the present invention, the following examples are given by way of illustration and not by way of limitation. All parts are by weight.

## Example 1

A sufficient amount of triphenyl sulfonium hexofluoro arsenate was added in crystalline form to an equal molar mixture of trimethylolpropane trithiolglycolate and diallylphthalate to produce a curable mixture having about 3% by weight of photoinitiator. The curable mixture was then applied onto the surface of a glass substrate by use of a drawbar to produce a coating of about 0.08 mm. The treated glass substrate was then placed under a GE HT37 medium pressure mercury arc lamp at a distance of about 152 mm. Cure of the curable mixture was achieved after about 1 minute exposure time which was determined by measuring the period of time the surface of the treated substrate was tack free.

## Example 2

Additional equal molar mixtures of a polyolefin component and a polythiol component were blended with about 3% by weight of photoinitiator and cured in accordance with the procedure of Example 1. The following table shows the ingredients in the mixture and the cure time which is measured in terms of rendering a treated glass substrate tack free after it has been treated with a 0.08 mm coating of the curable composition.

TABLE I

| Polyolefin | Polythiol | Photoinitiator | Cure Time |
|---|---|---|---|
| diallyl-carbonate | trimethylolpropane trithiolglycolate | triphenylsulfonium tetrafluoroborate | 15 sec. |
| triallyl-isocyanurate | " | triphenylsulfonium hexafluoroborate | 10 sec. |

## Example 3

There is added dropwise at a temperature of 60°C, 0.6 mole of allyl alcohol to a mixture while it was being stirred of 95 g (0.2 mole) of hexamethylenediisocyanate and 3 to 4 drops of stanous octoate. After the mixture was refluxed for one hour it was placed under vacuum to remove unreacted allyl alcohol. There was then added 0.2 mole of trimethylolpropane trithiolglycolate. The resulting mixture was then equally divided and to each portion respectively there was added 3 percent by weight of triphenylsulfonium hexafluoroarsenate and 4-methoxydiphenyliodoniumfluoroborate. The resulting curable mixtures were then applied onto an aluminum substrate and cured within 3—5 seconds using a pyrex filtered Hanovia 450 W medium pressure arc lamp at a distance of 152 mm.

## Example 4

A mixture was prepared by combining 2 grams of diethyleneglycol divinylether with 1 gram of pentaerythritol tetra-3-mercaptopropionate and 3% by weight of the resulting mixture of triphenylsulfonium hexafluoroantimonate. The mixture was then subjected to ultraviolet irradiation from a GE H3T7 medium pressure arc lamp at a distance of about 152 mm. The cured 0.08 mm film was produced after 5 seconds irradiation.

## Example 5

Sufficient 4,4′-diisopropyliodonium hexafluoroarsenate was added to a mixture of 66% by weight of diallyl isophthalate and 33% by weight of pentaerythritol tetra-3-mercaptopropionate to produce a photocurable composition having about 3% by weight of photoinitiator. The photocurable mixture was then applied onto a steel substrate at a thickness of about 0.08 mm and irradiated in accordance with the Example 3 to produce a tack free film within 20 seconds.

## Example 6

There was added sufficient triphenylsulfonium hexafluoroarsenate to a mixture of pentaerythritol-tetra-3-mercaptopropionate and a polyolefin resulting from the reaction of 0.1 mole of bisphenol-A-diglycidylether and diallyl amine which had been reacted together for about 2 hours. The resulting curable mixture was irradiated for 5 seconds after it had been applied as a 0.08 mm film onto the surface of an aluminum substrate. Irradiation was performed in the same manner as previously described. There was obtained a tack free film suitable as an insulating coating or dielectric film for a capacitor.

## Example 7

The procedure of Example 6 was repeated except that there was incorporated into the mixture of 0.5% by weight of 2,6-di-t-butyl-4-methylphenol as a stabilizer. Cure of the composition was again effected within 5 seconds. This established that the stabilizer did not interfere with the cure of the curable composition, indicating that the cure mechanism was not a free radical mechanism. Those skilled in the art would know that if the photoinitiator was benzophenone or other free radical photoinitiator as utilized in

the above-described Kehr et al. patent that the inhibitor would have interfered with the cure rate of the curable composition.

Although the above examples illustrate only a few of the very many curable compositions which can be made in accordance with the present invention, it should be understood that the curable compositions of the present invention can be made by blending a photoinitiator of formula (1) with a polyolefin (2) and polythiol of formula (3).

N.B. Hanovia, Xenon and Pyrex are all Trade Marks.

**Claims**

1. A liquid UV curable composition free of a free radical inhibitor characterized by

(A) a polyolefin component having the formula,

$$[A]\!-\!\!-[D]_x,$$

where x is an integer having a value of at least 2, A is a polyvalent organic radical or an organosilicon radical free of reactive olefinic unsaturation and consisting of chemically combined atoms selected from carbon, oxygen, nitrogen, phosphorous, silicon and mixtures thereof together with monovalent atoms of chlorine, bromine, fluorine or hydrogen, and D is an olefinically unsaturated monovalent organic radical,

(B) a polythio component having the formula,

$$G\!-\!(SH)_y,$$

where G is a polyvalent organic radical free of aliphatic unsaturation and y is an integer having a value of at least 2, and

(C) from 0.25% to 10% by weight of the UV curable composition, of a photodecomposable cationic photoinitiator of the formula,

$$(Y^+)_j\ (MX_k)^{-\ (k-l)}$$

where M is a metal or metalloid and $Y^+$ is a cation selected from

$$[(R)_a\ (R^1)_b\ Q]^+,\ [(R)_c\ (R^2)_d\ (R^3)_e\ D]^+,\ [(R)_f\ (R^4)_g\ (R^5)_h\ Z]^+,$$

wherein R is a monovalent aromatic organic radical, $R^1$ is a divalent aromatic organic radical, $R^2$ is an alkyl, cycloalkyl or substituted alkyl radical, $R^3$ is a polyvalent organic radical forming a heterocyclic or fused ring structure selected from aliphatic radicals and aromatic radicals, $R^4$ is a monovalent organic aliphatic radical selected from alkyl, alkoxy, cycloalkyl, haloalkyl and alkoxyalkyl. $R^5$ is a polyvalent organic radical forming an aromatic heterocyclic or fused ring structure, Q and X are halogen radicals selected from I, Br, Cl, or F, D is an element selected from sulfur, selenium or tellurium, Z is an element selected from N, P, As, Sb, or Bi, *a* is 0 or 2, *b* is 0 or 1, the sum of a + b is equal to 2 or to the valence of Q, *c* is 0 or 3, *d* is 0, 1 or 2, *e* is 0 or1, and the sum of *c* + *d* + *e* is a value equal to 3 or the valence of D, *f* is 0, 1, 2, 3 or 4, *g* is 0, 1 or 2, *h* is 0, 1 or 2, and the sum of *f* + *g* + *h* is a value equal to 4 or the valence of Z,

$j = k-l$

$l$ = valence of M and is an integer equal to 2 to 7 inclusive and

$k > l$ and is an integer having a value up to 8.

2. A curable composition as claimed in claim 1, where the polyolefin component is diallyl phthalate.

3. A curable composition as claimed in claim 1, where the polyolefin component is diallyl maleate.

4. A curable composition as claimed in claim 1, where the polyolefin component is triallyl cyanurate.

5. A curable composition as claimed in any one of claims 1 to 4, where the polythiol component is trimethylolpropane trithiolglycolate.

6. A curable composition as claimed in any one of claims 1 to 4 where the polythiol component is pentaerythritol tetra-3-mercaptopropionate.

7. A curable composition as claimed in any one of claims 1 to 4 where the photoinitiator is triphenylsulfonium hexafluoroarsenate.

8. A curable composition as claimed in any one of claims 1 to 7 where the photoinitiator is 4,4'-dimethyldiphenyliodonium hexafluorophosphate.

9. A curable composition as claimed in any one of claims 1 to 7 where the photoinitiator is triphenylsulfonium tetrafluoroborate.

10. A method for treating a substrate which comprises,

(1) applying a UV curable composition as claimed in any one of claims 1 to 9 onto the surface of the substrate, and

(2) exposing the treated substrate to ultraviolet light.

**Patentansprüche**

1. Flüssige, UV-härtbare Masse, die keinen Inhibitor für freie Radikale enthält, gekennzeichnet durch
(A) eine Polyolefin-Komponente der Formel

$$[A]\!-\!\!-[D]_x$$

worin x eine ganze Zahl mit einem Wert von mindestens 2 ist, A ein mehrwertiger organischer Rest oder ein Organosiliziumrest frei von reaktiver olefinischer Ungesättigtheit ist, der aus chemisch verbundenen Atomen aus Kohlenstoff, Sauerstoff, Stickstoff, Phosphor, Silizium und deren Mischungen zusammen mit einwertigen Atomen aus Chlor, Brom, Fluor oder Wasserstoff besteht, und D ein olefinisch ungesättigter einwertiger organischer Rest ist,

(B) eine Polythio-Komponente der Formel

$$G\!-\!(SH)_y$$

worin G ein mehrwertiger organischer Rest frei von aliphatischer Ungesättigtheit ist und y eine ganze Zahl mit einem Wert von mindestens 2 ist, und

(C) 0,25 bis 10 Gew.-%, bezogen auf die UV-härtbare Masse, eines photozersetzbaren kationischen Photoinitiators der Formel

$$(Y^+)_j\ (MX_k)^{-(k-l)}$$

worin M ein Metall oder Nichtmetall und $Y^+$ ein Kation ist, ausgewählt aus

$$[(R)_a\ (R^1)_b\ Q]^+,\ \ [(R)_c\ (R^2)_d\ (R^3)_e\ D]^+,\ \ [(R)_f\ (R^4)_g (R^5)_h\ Z]^+,$$

worin R ein einwertiger aromatischer organischer Rest, $R^1$ ein zweiwertiger aromatischer organischer Rest, $R^2$ ein Alkyl-, Cycloalkyl- oder substituierter Alkyl-Rest ist, $R^3$ ein mehrwertiger organischer Rest ist, der eine heterocyclische oder kondensierte Ringstruktur bildet, ausgewählt aus aliphatischen und aromatischen Resten, $R^4$ ein einwertiger organischer aliphatischer Rest ist, ausgewählt aus Alkyl, Alkoxy, Cycloalkyl, Haloalkyl und Alkoxyalkyl, $R^5$ ein mehrwertiger organischer Rest ist, der eine aromatische heterocyclische oder kondensierte Ringstruktur bildet, Q und X Halogenreste sind, ausgewählt aus J, Br, Cl und F, D ein Element ausgewählt aus Schwefel, Selen und Tellur ist, Z ein Element ausgewählt aus N, P, As, Sb und Bi ist, *a* den Wert 0 oder 2, hat, *b* den Wert 0 oder 1 hat, die Summe von $a + b$ gleich 2 oder der Wertigkeit von Q ist, *c* den Wert 0 oder 3 hat, *d* den Wert 0, 1 oder 2 hat, *e* den Wert 0 oder 1 hat und die Summe von $c + d + e$ gleich 3 oder der Wertigkeit von D ist, *f* den Wert 0, 1, 2, 3 oder 4 hat, *g* 0, 1 oder 2 ist, *h* 0, 1 oder 2 ist und die Summe von $f + g + h$ gleich 4 oder der Wertigkeit von Z ist,

$j = k - l$ ist,

$l$ = der Wertigkeit von M und eine ganze Zahl von 2 bis einschließlich 7 ist und

$k > l$ und eine ganze Zahl mit einem Wert von bis zu 8 ist.

2. Härtbare Masse nach Anspruch 1, dadurch gekennzeichnet, daß die Polyolefin-Komponente Diallylphthalat ist.

3. Härtbare Masse nach Anspruch 1, dadurch gekennzeichnet, daß die Polyolefin-Komponente Diallylmaleat ist.

4. Härtbare Masse nach Anspruch 1, dadurch gekennzeichnet, daß die Polyolefin-Komponente Triallylcyanurat ist.

5. Härtbare Masse nach irgendeinem der Ansprüche 1 bis 4, dadurch gekennzeichnet, daß die Polythiol-Komponente Trimethylolpropantrithiolglycolat ist.

6. Härtbare Masse nach irgendeinem der Ansprüche 1 bis 4, dadurch gekennzeichnet, daß die Polythiol-Komponente Pentaerythrit-tetra-3-mercaptopropionat ist.

7. Härtbare Masse nach irgendeinem der Ansprüche 1 bis 4, dadurch gekennzeichnet, daß der Photoinitiator Triphenylsulfoniumhexafluoroarsenat ist.

8. Härtbare Masse nach irgendeinem der Ansprüche 1 bis 7, dadurch gekennzeichnet, daß der Photoinitiator 4,4'-Dimethyldiphenyljodoniumhexafluorophosphat ist.

9. Härtbare Masse nach irgendeinem der Ansprüche 1 bis 7, dadurch gekennzeichnet, daß der Photoinitiator Triphenylsulfoniumtetrafluoroborat ist.

10. Verfahren zum Behandeln eines Substrates, gekennzeichnet durch

(1) Aufbringen einer UV-härtbaren Masse nach irgendeinem der Ansprüche 1 bis 9 auf die Oberfläche des Substrates und

(2) Aussetzen des überzogenen Substrates gegenüber ultraviolettem Licht.

**Revendications**

1. Composition liquide durcissable par les UV dépourvue d'inhibiteur producteur de radicaux libres, caractérisée en ce qu'elle comprend:

(A) un constituant polyoléfine répondant à la formule,

$$[A]\!-\!\!-\![D]_x,$$

dans laquelle x représente un nombre entier au moins égal à 2, A représente un radical organique polyvalent ou un radical organosilicium dépourvu d'insaturation oléfinique réactive et constitué par des atomes chimiquement combinés choisis parmi le carbone, l'oxygène, l'azote, le phosphore, le silicium et leurs mélanges avec des atomes monovalents de chlore, de brome, de fluor ou d'hydrogène, et D représente un radical organique monovalent oléfiniquement insaturé,

(B) un constituant polythiol répondant à la formule:

$$G\!-\!(SH)_y,$$

dans laquelle G représente un radical organique polyvalent, dépourvu d'insaturation aliphatique et y représente un nombre entier au moins égal à 2, et

(C) de 0,25% à 10% en poids de la composition durcissable par les UV d'un photo-initiateur cationique photo-décomposable répondant à la formule,

$$(Y^+)_j\ (MX_k)^{-\ (k-l)}$$

dans laquelle M représente un métal ou un métalloïde et $Y^+$ un cation choisi parmi

$$[(R)_a\ (R^1)_b\ Q]^+,\ [(R)_c\ (R^2)_d\ (R^3)_e\ D]^+,\ \ [(R)_f\ (R^4)_g\ (R^5)_h\ Z]^+,$$

sachant que R représente un radical organique aromatique monovalent, $R^1$ représente un radical organique aromatique, $R^2$ représente un radical alkyle, cycloalkyle ou alkyle substitué, $R^3$ représente un radical organique polyvalent formant une structure hétérocyclique ou cyclique condensée, choisi parmi des radicaux aliphatiques et des radicaux aromatiques, $R^4$ représente un radical organique aliphatique monovalent choisi parmi les groupes alkyles, alcoxy, cycloalkyles, haloalkyles et alcoxyalkyles, $R^5$ représente un radical organique polyvalent formant une structure aromatique hétérocyclique ou cyclique condensée, Q et X représentent des radicaux halogène choisis parmi I, Br, Cl ou F, D représente un élément choisi parmi le soufre, le sélénium, ou le tellure, Z représente un élément choisi parmi N, P, As, Sb ou Bi, *a* est égal à 0 ou à 2, *b* est égal à 0 ou à 1, la somme $a + b$ est égale à Z ou à la valence de Q, *c* est égal à 0 ou à 3, *d* est égal à 0, 1 ou 2, *e* est égal à 0 ou à 1, et la somme $c + d + e$ est égal à 3 ou à la valence de D, *f* est égal à 0, 1, 2,3 ou 4, *G* est égal à 0, 1 ou 2, *h* est égal à 0, 1 ou 2 est la somme $f + g + h$ est égale à 4 ou à la valence de Z,

$j = k-l$

$l$ = valence de M et représente un nombre entier compris entre 2 et 7, inclus et

$k > l$ et représente un nombre entier pouvant aller jusqu'à 8.

2. Composition durcissable selon la revendication 1, caractérisé en ce que le constituant polyoléfiné est le phtalate de diallyle.

3. Composition durcissable selon la revendication 1, caractérisée en ce que le constituant polyoléfiné est le malléate de diallyle.

4. Composition durcissable selon la revendication 1, caractérisée en ce que le constituant polyoléfiné est le cyanurate de triallyle.

5. Composition durcissable selon l'une quelconque des revendications 1 à 4, caractérisée en ce que le constituant polythiol est le trithiolglycolate de triméthylolpropane.

6. Composition durcissable selon l'une quelconque des revendications 1 à 4, caractérisée en ce que le constituant polythiol est le tétra-mercapto-3-propionate de pentaérythrital.

7. Composition durcissable selon l'une quelconque des revendications 1 à 4, caractérisée en ce que le photo initiateur est l'hexafluoroarséniate de triphénylsulfonium.

8. Composition durcissable selon l'une quelconque des revendications 1 à 7, caractérisé en ce que le photoinitiateur est l'hexafluorophosphate de diméthyl-4,4' diphényliodonium.

9. Composition durcissable selon l'une quelconque des revendications 1 à 7, caractérisé en ce que le photoinitiateur est le tétrafluoroborate de triphénylsulfonium.

10. Procédé de traitement d'un substrat, caractérisé en ce qu'il comprend:

(1) l'application d'une composition durcissable par les UV selon l'une quelconque des revendications 1 à 9 sur la surface du substrat, et

(2) l'exposition du substrat traité à la lumière ultraviolette.